Europäisches Patentamt

European Patent Office

Office européen des brevets

(11) Publication number: **0 362 571**
**A2**

## (12) EUROPEAN PATENT APPLICATION

(21) Application number: **89116609.2**

(22) Date of filing: **08.09.89**

(51) Int. Cl.5: **H01L 21/60 , H01L 21/90**

(30) Priority: **07.10.88 US 254633**

(43) Date of publication of application:
**11.04.90 Bulletin 90/15**

(84) Designated Contracting States:
**DE FR GB**

(71) Applicant: **International Business Machines Corporation**
**Old Orchard Road**
**Armonk, N.Y. 10504(US)**

(72) Inventor: **Cronin, John Edward**
**RD No.3, Box 3254**
**Milton Vermont 05468(US)**
Inventor: **Cronin, Susan Frances**
**RD No.3, Box 3254**
**Milton Vermont 05468(US)**
Inventor: **Kaanta, Carter Welling**
**Box 23**
**Essex Junction Vermont 05452(US)**
Inventor: **Koburger III, Charles William**
**20 Bixby Hill Road**
**Essex Junction Vermont 05452(US)**
Inventor: **Luce, Stephen Ellinwood**
**RR1 Box 580**
**Cambridge Vermont 05444(US)**
Inventor: **Pearson, Dale Jonathan**
**P.O. Box 569**
**Somers, N.Y. 10589(US)**

(74) Representative: **Oechssler, Dietrich, Dr. rer. nat.**
**IBM Deutschland GmbH Patentwesen und Urheberrecht Schönaicher Strasse 220**
**D-7030 Böblingen(DE)**

(54) Method for forming semiconductor components.

(57) A method of forming semiconductor devices components wherein there are at least two exposed conducting regions having insulating material overlying said regions. The insulating material is subject to etching by a given etchant. At least one, but less than all of the regions are covered with an etch resistant material, preferably an electrical conducting material, which also preferably covers additional electrical conducting or semiconducting regions. Thereafter, all the regions are subjected to the given etchant, but only those regions having the insulating material not covered with the etch resistant material are removed. Preferably, at this point, a layer of conducting material is deposited over all the regions.

FIG.1B

FIG.1D

FIG.1E

1a

# METHOD OF FORMING SEMICONDUCTOR COMPONENTS

This invention relates generally to the fabrication of semiconductor components by photolithographic processes.

In the formation of semiconductor devices it is necessary to both provide desired electrical contact between certain regions of the devices formed and also to prevent contact between various other regions of the devices formed on the substrate. Conventionally, one technique for accomplishing this is by utilizing photoresist and masking techniques wherein those areas to be exposed for electrical contact are patterned in the photoresist, and then by developing the patterned photoresist, to thereby expose the desired underlying regions. This technique normally requires several successive masks to perform the entire process, and in its performance each succeeding mask must be precisely aligned with the previously exposed and developed structure to insure that only the desired regions are ultimately exposed, and other regions remain covered or protected, or additional masking may be required. However, as the technology advances, allowing for formation of smaller and smaller devices, it is increasingly difficult to maintain precise overlay tolerance, with the result that even small misalignments of the masks will result in the exposure of small portions or "borders" of regions that are intended to remain covered. Hence, electrical connections, e.g. by an overlay deposition of a metal will connect not only the desired locations but also those exposed border portions of the undesired locations.

Thus it is a principal object of this invention to provide a technique applicable to the production of semiconductor devices by photolithographic processes in which exposed regions of the same material, such as polysilicon, can be selectively masked to prevent unintended contact with the selectively masked regions thus providing what are known as borderless contacts.

It is another object of the invention to provide a method for forming a semiconductor device by photolithographic processes, where unwanted electrical contact between different regions of the semiconductor devices are prevented.

These objects are achieved by methods as disclosed in claims 1, 7 and 8.

Advantageous embodiments of the inventive method according to claim 1 are disclosed in the subclaims.

The invention will become more apparent from the following detailed description taken in conjunction with the accompanying drawings.

Figures 1A-1F are sectional views, somewhat diagrammatic, showing the sequence of steps and processes to selectively protect a desired region on a semiconductor chip according to the invention; and

Figures 2A-2F are sectional views somewhat diagrammatic, of a sequence of steps and processes similar to Figures 1A-1F of another embodiment of this invention.

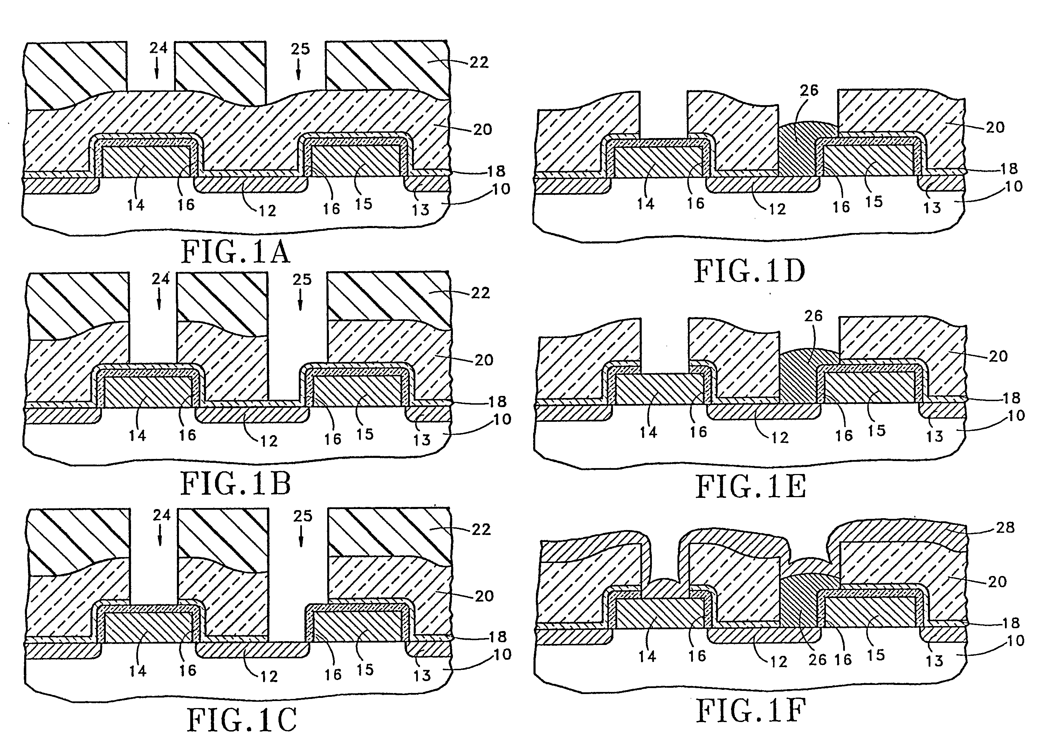

Referring now to the drawings, and for the present to Figures 1A through 1F, a diagrammatic representation of the steps of one embodiment of this invention is shown. Figure 1A shows a typical semiconductor fabrication at the stage of processing wherein a silicon substrate 10 has been provided with diffusion or doped regions 12, 13 and conducting layers 14, 15 preferably of polysilicon which will form gate electrodes in the semiconductor devices which are to be formed on the silicon substrate. The conducting layers 14, 15 have electrically insulating layers 16 capping them, which insulating layers may be oxides, nitrides, or the like. A process for forming a capping layer is as follows: a layer of polysilicon is patterned by photoresist techniques with an oxide or nitride mask. The polysilicon is etched, leaving the mask and underlying polysilicon in tact. Side wall oxide insulators are formed by CVD oxide deposition and RIE etch (as will be described presently); all as is well known in the art. Overlying the entire surface of the chip is an etch-stop passivation layer 18. This may be aluminum oxide, or the like. This can be applied by reactive sputtering. A smoothing layer of reflowed glass 20 overlies the etch stop layer 18. On top at the glass layer 20 is a photoresist material 22 which has been exposed through a mask and developed to produce a series of openings 24, 25 in a conventional manner. Under ideal conditions, the mask used to pattern the photoresist would have had the exact size and shape, and been exactly positioned to expose the conducting layer 14 and diffused area 12, but leave covered the conducting layer 15. However, as was described above, this is not always the case, and these series of Figures 1A-1F demonstrate how the exposed portion of conductor 15 can be protected while the conductor 14 and diffusion area 12 are exposed for electrical contact.

The glass 20 which is exposed through the openings 24, 25 is etched using reactive ion etching in gasses such as $CHF_3$ + $CO_2$ or $CH_4$ at low pressure, e.g. about 133.32 $\mu$bar (100 mil Torr) or less, which etching is stopped by etch stop layer 18 as shown in Figure 1B. The exposed etch stop 18 is removed by reactive ion etching in $BCl_3$ at low pressure, e.g. 133.32 $\mu$bar (100 mil Torr) or less as shown in Figure 1C. This reveals a portion of the insulating layer 16 overlying a portion of the conducting layer 14 and also the insulating layer overlying one edge portion of the conducting layer 15 and a portion of diffusion area 12 as depicted in Figure 1C. At this point it is desired to create an electrical contact with conducting layer 14 and diffusion layer area 12, but keep conducting layer 15 electrically insulated. This is accomplished by the following steps which start with the selective deposition and growth of a conducting material such as tungsten on the exposed diffusion areas 12 as shown at 26 in Figure 1D. A preferred technique of the selective deposition and growth of tungsten is as follows: This is accomplished by low pressure (e.g. 266.64 μbar (200 mil Torr) or less) CVD growth of tungsten utilizing WF₆ and H₂ gasses at a temperature of about 500° C or less.

The tungsten is selectively deposited onto the diffusion region 12 and grown so that it completely covers the capped portion of the conductor 15 which is exposed as shown in Figure 1D. At this point, the tungsten 26 provides an electrical connection to the diffusion region 12, but is electrically insulated from the conducting layer 15 by the insulating layer 16 formed thereon. The tungsten 26 also protects the insulating layer 16 on conducting layer 15 from exposure, which is critical for the next step of the process.

In the next step of the process, the exposed insulating layer 16 overlying the conducting layer 14 is removed by blanket etch to expose the surface of the conducting layer 14 which will result in the structure shown in Figure 1E. A preferred etch process is the same process as used to remove layer 20 as previously described.

At this point in the process the conducting layer 14 is exposed, as desired. Diffusion region 12 is covered by tungsten 26. Conducting layer 15 is electrically insulated by virtue of insulating layer 16 which was protected from removal during the blanket etch by the tungsten 26. A blanket deposition of metal 28 can now be performed as shown in Figure 1F to provide electrical connection to conducting layer 14 and diffusion region 12. This can be conventionally sputtered aluminum, or certain aluminum alloys, or any other desired metal. After the aluminum is deposited, it is masked, patterned and etched to define a conductor layer in a conventional manner.

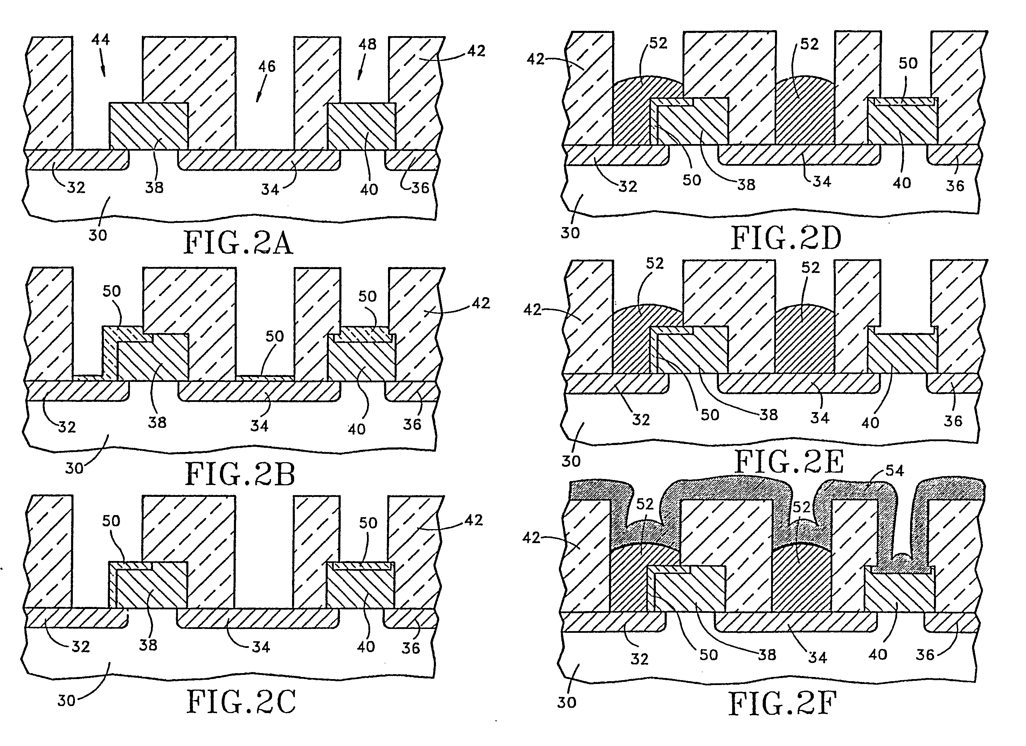

Another embodiment of the invention is shown in Figures 2A through 2E. In Figure 2A, a silicon substrate 30 is shown having diffusion regions 32, 34, and 36. Conducting layers 38, 40 of polysilicon are deposited on the silicon substrate 30. An overlying glass layer 42 has been patterned and etched by photoresist methods as previously described to form openings 44, 46, and 48, all as shown in Figure 2A. In this case, it is desired to provide electrical contact diffusion regions 32 and 34, and conducting layer 40, and prevent electrical contact to conducting layer 38. Again, the exposure of a portion of the conducting layer 38 is not desired, but is due to misalignment of the mask.

In this embodiment, a thermal oxide 50 is grown on diffusion regions 32 and 34 and on conducting layers 38 and 40. This is done in an oven at 800° C or less in an oxygen atmosphere. In this embodiment, reliance is made on the fact that the thermal oxide grows about three times as fast on polysilicon layers 38 and 40 as on the diffusion regions 32, 34 which are each a single crystal. The resulting structure is shown in Figure 2B. The thermally grown oxide is reactively ion etched (RIE), with etching being stopped after the oxide is completely removed from the diffusion zones 32, 34, but before it is removed from the polysilicon layers 38, 40 as shown in Figure 2C. A suitable process for RIE is the same as used to etch layer 20 as described above.

From this point on, the processing is identical to that as previously described. A metal 52 such as tungsten is selectively deposited and grown on diffusion region 32 and 34. The growth of the tungsten in diffusion region 34 grows to cover the edge of conducting layer 38 and is insulated therefrom by insulating oxide 50 but does not grow on oxide 50 overlying conducting layer as shown in Figure 2D. The oxide 50 overlying conducting layer 40 is removed by a blanket RIE etch as was used to remove layer 20 as described above, which does not affect the oxide layer 50 overlying the edge portion of conducting layer 38 which is protected by the tungsten as shown in Figure 2E, and a blanket deposition of metal, such as aluminum is applied, by sputtering as previously described. The result is as shown in Figure 2F. This results in connection to conductor 34, 40, 32, and protects conductor 38.

Although the invention has been described in some detail, various adaptions and modifications can be made without departing from the scope as defined in the appended claims.

## Summary of the Invention

An improved process of forming semiconductor components on a substrate material is provided wherein there are at least two regions of material to be electrically connected and at least one additional region, of the same material as at least one of said regions, which is to be electrically insulated. The regions are all covered with an insulating material which can be etched by a given etchant, and thereafter the region or region which are to remain electrically insulated are covered with a additional material which resists the etchant. Thereafter the entire surface is exposed to the etchant, which will remove the additional material at the locations wherein the insulation material is exposed but not remove the insulating material at the locations covered by the additional material.

## Claims

1. Method for forming semiconductor components on a substrate material, and wherein there are at least two exposed regions having an overlying insulating material being subject to etching by a given etchant, comprising the steps selectively depositing in at least a portion of a selected one but less than all of said exposed regions a material that resists said etchant and thereafter exposing all of the regions to said etchant, where only said regions without said etch resisting material will be etched.

2. Method according to claim 1, wherein said etch resisting material is selectively grown to cover said portion of said selected one of said exposed regions.

3. Method according to claim 2, wherein the regions which are covered with said etch resisting material include a second material which differs from insulating material, and which second material supports the growth of said etch resisting material and said insulating material resists the growth of said etch resisting material, and wherein said etch resisting material is grown only in regions which have said second material and in regions which have said insulating material as well as said second material and said etch resisting material covers both of said regions.

4. Method according to claim 3, wherein said second material is a semiconductor, preferably doped silicon.

5. Method according to any one of claims 1 to 4, wherein the insulating layer is a deposited capping layer or a thermally grown oxide.

6. Method according to any one of claims 2 to 5, wherein the etch resisting material is a selectively grown metal, preferably tungsten.

7. Method for forming borderless contacts on a semiconductor substrate having a plurality of gate electrodes disposed on an exposed surface thereof, each of the plurality of gate electrodes having sidewalls covered by insulating sidewall spacers and an upper surface covered by an insulating cap, comprising the steps of: forming a passivation layer on the exposed surface of the substrate; etching through selected portions of the passivation layer to expose the insulating cap of selected ones of the plurality of gate electrodes and to expose regions of the substrate adjacent to each of the plurality of gate electrodes; selectively forming a first conductor on said exposed regions of the substrate and the insulating cap on the adjacent gate electrode; treating the substrate in an etchant that removes the exposed insulator caps without appreciably etching said first conductor, to expose said selected ones of the plurality of gate electrodes; and forming a second conductor on said selected ones of the plurality of gate electrodes.

8. Method for forming borderless contacts on a semiconductor substrate having a plurality of gate electrodes consisting of doped polycrystalline semiconductor material and being disposed on an exposed surface thereof comprising the steps of: growing a layer of thermal oxide on the exposed surfaces of said gate electrodes and of the semiconductor substrate, where the thermal oxide grows faster on the doped polycrystalline semiconductor material than on the semiconductor substrate etching the thermal oxide until it is removed on the semiconductor substrate, forming a first conductor on said exposed regions of the substrate and on the thermal oxide on the top of those gate electrodes bordering with their thermal oxide on one of the exposed regions of the substrate, treating the substrate in an etchant that removes the exposed thermal oxide without appreciably etching said first conductor, and forming a second conductor on said first conductor and on the exposed gate electrodes.

9. Method according to claim 7 or 8, wherein said first conductor is made of tungsten and/or said second conductor is made of aluminum.

EP 0 362 571 A2

FIG.1A

FIG.1B

FIG.1C

FIG.1D

FIG.1E

FIG.1F

FIG.2A  FIG.2B  FIG.2C  FIG.2D  FIG.2E  FIG.2F